# EUROPÄISCHE PATENTSCHRIFT

(11) **EP 2 884 197 B1**
(45) Veröffentlichungstag und Bekanntmachung des Hinweises auf die Patenterteilung: **08.02.2017**
(21) Anmeldenummer: 13005816.7
(22) Anmeldetag: 13.12.2013
(51) Int. Cl.: F24H 1/00, F24H 1/12, F24H 9/18, F28F 3/12, H01R 12/00

(54) **Elektrische Heizvorrichtung und Verfahren zu deren Herstellung**
Electric heating device and method for its production
Dispositif de chauffage électrique et son procédé de fabrication

(43) Veröffentlichungstag der Anmeldung: 17.06.2015
(73) Patentinhaber: Eberspächer catem GmbH & Co. KG, 76863 Herxheim (DE)
(72) Erfinder: Bohlender, Franz, 76870 Kandel (DE); Niederer, Michael, 76889 Kapellen-Drusweiler (DE)
(74) Vertreter: Grünecker Patent- und Rechtsanwälte PartG mbB

(56) Entgegenhaltungen:
- EP-A1- 2 353 898
- EP-A1- 2 440 005
- WO-A1-2010/069354
- DE-A1-102009 045 741

## Beschreibung

Die vorliegende Erfindung betrifft eine elektrische Heizvorrichtung, insbesondere zur Erwärmung von flüssigen Temperiermedien in einem Kraftfahrzeug sowie ein Verfahren zu deren Herstellung. Die vorliegende Erfindung betrifft insbesondere einen so genannten "Coolant Heater", d.h. eine elektrische Heizvorrichtung zur Erwärmung eines flüssigen Temperiermediums, welches technische Aggregate in einem Kraftfahrzeug erwärmt, d.h. Teil eines Temperiermediumkreislaufs ist, der neben der elektrischen Heizvorrichtung üblicherweise Wärmetauschflächen zwischen dem Temperiermediumkreislauf und zumindest einer Oberfläche eines technischen Aggregates umfasst. Bei diesem technischen Aggregat kann es sich um den Motorblock eines Verbrennungsmotors handeln. Die vorliegende Erfindung hat aber hat aber insbesondere die Verwendung der elektrischen Heizvorrichtung im Rahmen der Elektromobilität im Blick. So wird in einer Einbausituation der erfindungsgemäßen elektrischen Heizvorrichtung insbesondere Wärme mit der Oberfläche einer Batterie getauscht, die mit Hilfe der von der elektrischen Heizvorrichtung erzeugten Wärme erwärmt wird. Hierin liegt der Hauptanwendungsfall der erfindungsgemäßen elektrischen Heizvorrichtung.

Die vorliegende Erfindung geht mit den oberbegrifflichen Merkmalen von Anspruch 1 von einer elektrischen Heizvorrichtung aus, die aus der auf die Anmelderin zurückgehenden EP 2 440 005 A1 bekannt ist. Bei der elektrischen Heizvorrichtung nach der EP 2 440 005 A1 wird die Anschlussleiterplatte durch seitlich durch in ein Anschlussgehäuse hineinragende Kontaktstifte elektrisch mit einer Steuerleiterplatte verbunden. Die Steuerleiterplatte schaltet dabei den Leistungsstrom zur Ansteuerung der einzelnen elektrischen Heizelemente, der über die Anschlussleiterplatte zu den einzelnen Anschlusselementen des elektrischen Heizelementes geleitet wird.

Der vorliegenden Erfindung liegt das Problem zugrunde, eine elektrische Heizvorrichtung der eingangs genannten Art anzugeben, die sich einfacher herstellen lässt. Des Weiteren will die vorliegende Erfindung ein Verfahren angeben, mit dem sich insbesondere eine elektrische Heizvorrichtung der eingangs genannten Art leichter und damit wirtschaftlicher herstellen lässt.

Mit Blick auf die vorrichtungsmäßige Aufgabenstellung wird mit der vorliegenden Erfindung eine elektrische Heizvorrichtung mit den Merkmalen von Anspruch 1 angegeben.

Bei dieser elektrischen Heizvorrichtung ist die Anschlussleiterplatte seitlich über das Gehäuse hinaus verlängert. Dementsprechend überragt die Anschlussleiterplatte das Gehäuse der elektrischen Heizvorrichtung. Dieses Gehäuse der elektrischen Heizvorrichtung besteht üblicherweise im Wesentlichen aus einem Gehäuseunterteil und einem Gehäusedeckel, wobei der Gehäusedeckel in der Regel einen umlaufenden Rand hat, der die Anschlusskammer umfänglich umgibt, welcher durch einen Anschlussgehäusedeckel abgeschlossen ist.

Mit Blick auf eine gute Wärmeübertragung an das zu erwärmende Medium und zur Vermeidung von Wärmeverlusten an die Umgebung wird vorzugsweise die Zirkulationskammer von einer als Kunststoffteil, insbesondere als Kunststoff-Spritzgussteil ausgebildeten Gehäusewanne umgeben, auf welche üblicherweise unter Zwischenlage eines Dichtelements der Gehäusedeckel aus Metall aufgesetzt ist, an welchem die Heizrippen üblicherweise einteilig ausgeformt sind. Bei dem Gehäusedeckel handelt es sich üblicherweise um ein Druckgussteil, insbesondere um ein Aluminium-Druckgussteil. Die Zirkulationskammer wird bei dieser bevorzugten Ausgestaltung lediglich begrenzt einerseits durch den metallischen Gehäusedeckel und ein Gehäuseunterteil, welches die Seitenwände wie auch den Boden der Zirkulationskammer bildet, wobei beide Gehäuseteile üblicherweise jeweils einteilig Funktionsflächen ausbilden, durch welche die beiden Gehäuseteile unmittelbar oder über ein mit diesen Funktionsflächen zusammenwirkendes Befestigungselement miteinander verbunden sind. Die Gehäusewanne, d.h. das Gehäuseunterteil, bildet üblicherweise auch einteilig Anschlussstutzen aus, welche die zuvor erwähnten Rohranschlüssen definieren können.

Das Gehäuse, bevorzugt der Gehäusedeckel an seinem umfänglichen Rand, hat vorzugsweise eine Anschlussleiterplatten-Durchführöffnung, durch welche die Anschlussleiterplatte hindurchgeführt ist und durch welche die Anschlussleiterplatte das Gehäuse in Richtung auf ein Steuergehäuse überragt. Erfindungsgemäß hat dieses Steuergehäuse eine Anschlussleiterplatten-Anschlussöffnung, die den das eigentliche Gehäuse überragenden Endbereich der Anschlussleiterplatte in sich aufnimmt. Die erfindungsgemäße elektrische Heizvorrichtung ist eine elektrische Heizvorrichtung in baulicher Einheit mit der Steuervorrichtung, d.h. der Wärme erzeugende Teil der elektrischen Heizvorrichtung ist als Einheit mit dem diesen Leistungsteil steuernden Steuerteil verbunden. Dieser Steuerteil wird in dem Steuergehäuse aufgenommen. Nach der vorliegenden Erfindung sind die Anschlussleiterplatten-Durchführöffnung und die Anschlussleiterplatten-Anschlussöffnung so ausgebildet, dass der freie Endbereich der Anschlussleiterplatte durch diese Öffnungen hindurchpasst. Eine mechanische Wechselwirkung zwischen der Anschlussleiterplatte und einer dieser Öffnungen ist nicht notwendig.

Nach der vorliegenden Erfindung ist weiterhin die Anschlussleiterplatte unmittelbar an Leiterbahnen einer Steuerleiterplatte angeschlossen. Dementsprechend sind an der Anschlussleiterplatte ausgebildete Leiterbahnen unmittelbar mit Leiterbahnen der Steuerleiterplatte kontaktiert. Diese Steuerleiterplatte ist in dem Steuergehäuse aufgenommen. Üblicherweise erstrecken sich die Steuerleiterplatte und die Anschlussleiterplatte rechtwinklig zueinander, so dass endseitig an der Anschlussleiterplatte freiliegende Anschlusskontakte durch die Steuerleiterplatte hindurchgesteckt werden können. Es versteht sich von selbst, dass die Steuerleiterplatte zum unmittelbaren elektrischen Anschluss Steckelemente umfasst, die mit Gegenelementen der Anschlussleiterplatte zusammenwirken. Üblicherweise sind an der Anschlussleiterplatte die männlichen Steckelemente vorgesehen, wohingegen die Steuerleiterplatte die weiblichen Steckelemente aufweisen kann. Im Hinblick auf einen möglichst kompakten Aufbau umfasst die Steuerleiterplatte hierzu vorzugsweise weibliche Steckelemente, wie sie in der auf die vorliegende Anmelderin zurückgehenden EP 2 236 330 A1 beschrieben sind. Die Anschlussleiterplatte besteht dabei vorzugsweise aus einer Kunststoffplatte und einer damit verbundenen gestanzten und die elektrischen Leiterbahnen ausbildenden Blechplatine. Aus dieser Blechplatine sind die Kunststoffplatte endseitig überragende Steckerzungen ausgeformt, die die männlichen Steckelemente der unmittelbaren Steckverbindung zwischen der Anschlussleiterplatte und der Steuerleiterplatte ausbilden. Die elektrische Kontaktierung zwischen der Anschlussleiterplatte und der Steuerleiterplatte wird vorzugsweise alleine durch Aufstecken der beiden Leiterplatten aufeinander bewirkt. Ein Verlöten der Kontakte ist danach entbehrlich. So können die beiden Leiterplatten zunächst fertig montiert und eingebaut werden. Die Anschlussleiterplatte wird in das Gehäuse eingesetzt; die Steuerleiterplatte in das Steuergehäuse. Die Steuerleiterplatte wurde zuvor mit sämtlichen elektronischen bzw. elektrischen Bauteilen bestückt, die dabei durch herkömmliche Löt-Techniken an die Leiterbahnen der Steuerleitplatte elektrisch angeschlossen worden sind. Die in dieser Weise vorbereitete Steuerleitplatte muss danach lediglich durch Aufstecken elektrisch verbunden werden, um den Steuerteil mit dem Leistungsteil elektrisch zu kontaktieren.

Indem die Anschlussleiterplatte unmittelbar mit den Leiterbahnen der Steuerleiterplatte in der zuvor beschriebenen Weise elektrisch kontaktiert ist, wird der Montageaufwand zur Herstellung der elektrischen Heizvorrichtung deutlich vermindert. Auch können der Leistungsteil und der Steuerteil getrennt voneinander vorbereitet werden. So kann das gesamte Steuergehäuse in einer Elektronikfertigung fertig montiert und lediglich durch Anflanschen des Steuergehäuses an das Gehäuses des Leistungsteils die notwendige elektrische Verbindung erzeugt werden. Die Komponenten lassen sich einfach austauschen. Auch können die Teile zunächst vor dem Zusammenbau jeweils für sich auf Funktionstauglichkeit geprüft werden. Dadurch wird die Ausschussrate verringert.

Gemäß einer bevorzugten Weiterbildung der vorliegenden Erfindung ist Anschlussleiterplatten-Anschlussöffnung als Schiebeführung für die Anschlussleiterplatte ausgebildet. Dementsprechend haben die Anschlussleiterplatten regelmäßig an ihrem Außenumfang und die Anschlussleiterplatten-Anschlussöffnung des Steuergehäuses an ihrem Innenumfang korrespondierende Führungsflächen. Diese Führungsflächen bewirken eine exakte Positionierung der Anschlussleiterplatte relativ zu dem Steuergehäuse und erleichtern somit das Finden der Steckpositionen zwischen der Anschlussleiterplatte und der Steuerleiterplatte. Die Schiebeführung ist üblicherweise so exakt ausgebildet, dass männliche Steckelemente der Anschlussleiterplatte bereits beim Aufstecken des Steuergehäuses auf die Anschlussleiterplatte mit den weiblichen Steckelementen der Steuerleiterplatte fluchten, so dass sich bei einer weiteren Aufschiebebewegung zwangsläufig die gewünschte elektrische Steckverbindung ergibt.

Dabei können steuergehäuseseitig zusätzliche Verbindungselemente, wie beispielsweise Rastnasen oder -nocken bzw. Gegenflächen für solche Rastnasen bzw. -nocken vorgesehen sein, die mit korrespondierend hierzu an der Anschlussleiterplatte ausgebildeten mechanischen Befestigungselemente kooperieren, um das Steuergehäuse zumindest vorläufig nach dem Aufschieben zu fixieren und zu halten. Danach können Befestigungsschrauben das Steuergehäuse endgültig an dem Gehäuse des Leistungsteils fixieren.

Gemäß einer weiteren bevorzugten Ausgestaltung der vorliegenden Erfindung, bei welcher die Anschlussleiterplatte in der zuvor beschriebenen Weise aus einer Kunststoffplatte und einer damit verbundenen gestanzten und elektrische Leiterbahnen ausbildenden Blechplatine gebildet ist, weist die Kunststoffplatte zumindest eine Messzungenaufnahme für eine Messleitungsanschlusszunge auf. Die Messleitungsanschlusszunge ist an einem Ende einer Messleitung vorgesehen, deren anderes Ende zu einem in dem Gehäuse aufgenommenen Messfühler führt. Hierbei handelt es sich üblicherweise um einen Thermofühler, der die Temperatur des in dem Gehäuse erwärmten Mediums erfasst. Solche Messfühler sind insbesondere bei elektrischen Heizvorrichtungen für die Erwärmung von flüssigen Fluiden gewünscht. Die mindestens eine Messleitungsanschlusszunge ist dabei elektrisch an eine Leiterbahn der Steuerleiterplatte angeschlossen. Die Kontaktzungenaufnahme ist dabei vorzugsweise wie das Aufnahmeelement eines herkömmlichen Steckers ausgebildet, in dem die Messleitungsanschlusszunge unverlierbar gehalten ist und endseitig an der Anschlussleiterplatte freiliegt. Gewünscht ist auch hier eine Ausgestaltung, bei welcher der Messleitungsstrang allein durch Aufstecken elektrisch an die Steuerleiterplatte angeschlossen wird.

Zur Lösung des verfahrensmäßigen Problems wird mit der vorliegenden Erfindung ein Verfahren mit den Merkmalen von Anspruch 7 vorgeschlagen. Bei diesem Verfahren zur Herstellung einer elektrischen Heizvorrichtung wird zunächst das elektrische Heizelement in der Heizrippe angeordnet. Üblicherweise werden mehrere elektrische Heizelemente entweder in eine, üblicherweise aber in verschiedene Heizrippen eingebracht. Die Heizrippen haben hierzu eine üblicherweise U-förmige Ausnehmung, die sich zu der Anschlusskammer öffnen. Nach dem Einbringen des bzw. der elektrischen Heizelemente liegen Anschlusselemente der einzelnen Heizelemente in der Anschlusskammer frei. Auf diese freiliegenden Anschlusselemente wird im Wesentlichen parallel zu der Einbringrichtung des bzw. der Heizelemente in die Heizrippen die zuvor bereits erwähnte Anschlussleiterplatte auf die Anschlusselemente aufgeschoben. Dadurch werden an der Anschlussleiterplatte ausgebildete Leiterbahnen mit den Anschlusselementen der elektrischen Heizvorrichtung bzw. der mehreren Heizvorrichtungen kontaktiert. Die Anschlussleiterplatte wird dabei so vorgesehen, dass diese zumindest einseitig das Gehäuse des Leistungsteils überragt. Danach wird ein Steuergehäuse als vormontierte Einheit in einer im Wesentlichen in der Ebene der Anschlussleiterplatte liegenden Richtung auf die Anschlussleiterplatte aufgeschoben. Das Aufschieben erfolgt dementsprechend rechtwinklig zu der Einbringrichtung der Heizelemente in die Heizrippen. Beim Aufschieben des Steuergehäuses werden elektrische Anschlüsse der Anschlussleiterplatte mit Leiterbahnen einer in dem Steuergehäuse angeordneten Steuerleiterplatte verbunden. Dementsprechend ergibt sich nach dem Aufstecken bereits eine elektrische Verbindung zwischen den beiden Leiterplatten in der zuvor beschriebenen Weise. Es ist nicht notwendig, nach dem mechanischen Fügen von Steuergehäuse und Gehäuse des Leistungsteils Lötverbindungen oder dergleichen zwischen den Leiterplatten vorzusehen.

So lässt sich die elektrische Heizvorrichtung mit dem erfindungsgemäßen Verfahren vereinfacht herstellen. Die zur elektrischen Kontaktierung der Anschlussleiterplatte mit der Steuerleiterplatte notwendigen Verfahrensschritte sind deutlich verringert.

Weitere Einzelheiten und Vorteile der vorliegenden Erfindung ergeben sich aus der nachfolgenden Beschreibung von zwei Ausführungsbeispielen in Verbindung mit der Zeichnung. In dieser zeigen:
- Figur 1: eine teilweise geschnittene perspektivische Seitendarstellung eines ersten Ausführungsbeispiels der vorliegenden Erfindung;
- Figur 2: eine Explosionsdarstellung des in Figur 1 gezeigten ersten Ausführungsbeispiels der vorliegenden Erfindung;
- Figur 3: eine in der X-Y-Ebene liegende Querschnittsansicht des ersten Ausführungsbeispiels von oben;
- Figur 4: eine in der X-Z-Ebene liegende Längsschnittsansicht des ersten Ausführungsbeispiels;
- Figur 5: eine in der Y-Z-Ebene liegende Querschnittsansicht des ersten Ausführungsbeispiels;
- Figur 6: eine perspektivische Darstellung einer in der X-Y-Ebene liegenden Längsschnittansicht von unten, d.h. auf einen Gehäusedeckel;
- Figur 7: eine perspektivische Seitenansicht auf ein Leistungsteil des Ausführungsbeispiels;
- Figur 8: ein vergrößertes Detail in einer Längsschnittansicht in der X-Y-Ebene von Leistungsteil und Steuerteil;
- Figur 9: eine perspektivische Draufsicht auf das offene Steuergehäuse vor dem Einbringen der Leiterplatte;

- Figur 10: eine perspektivische Draufsicht nach Figur 9 mit darin montierten Leistungstransistoren und weiteren, der Steuerleiterplatte zugeordneten Elementen innerhalb des Steuergehäuses;
- Figur 11: eine perspektivische Draufsicht gemäß den Figuren 9 und 10 nach Montage der Steuerleiterplatte; und
- Figur 12: eine perspektivische Explosionsdarstellung des Gehäuses für ein anderes Ausführungsbeispiel der vorliegenden Erfindung.

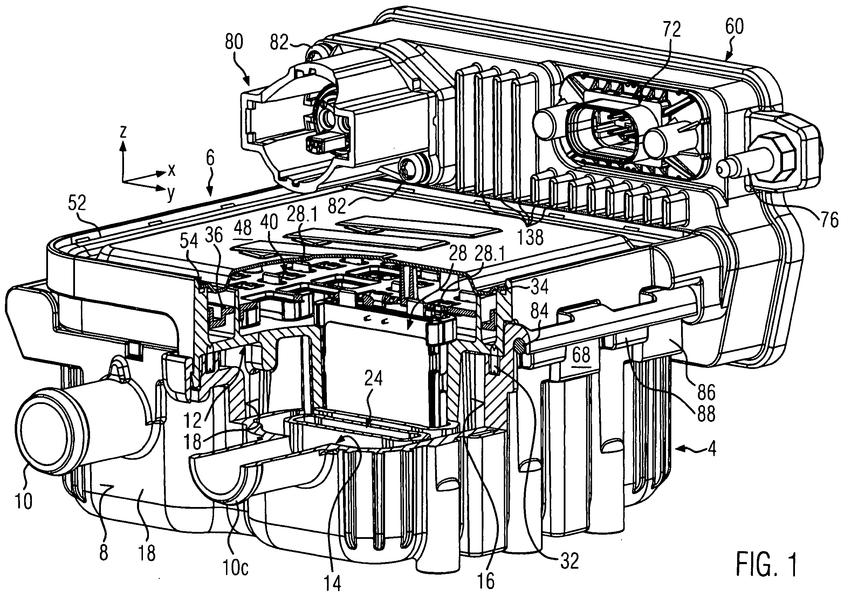

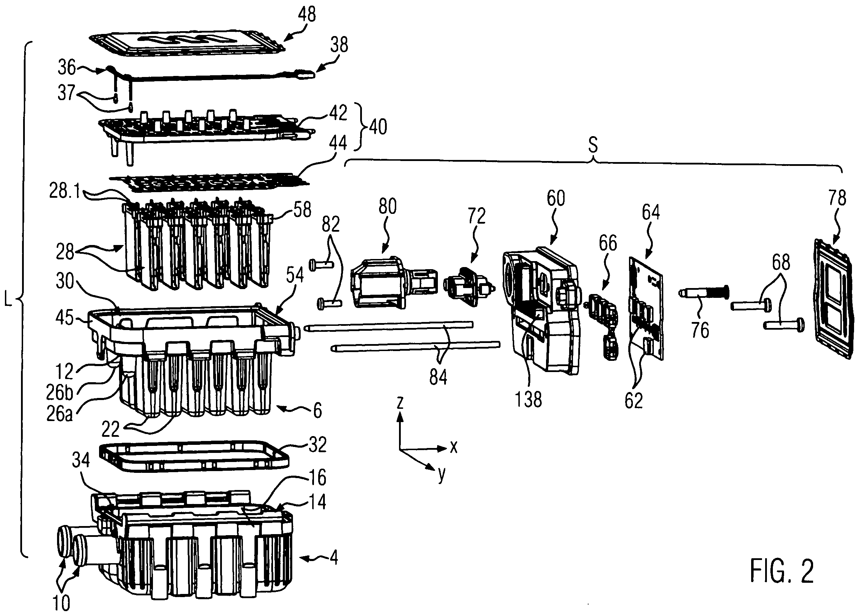

Die Figuren 1 und 2 lassen die wesentlichen Bestandteile des ersten Ausführungsbeispiels erkennen. Bei diesem Ausführungsbeispiels handelt es sich um eine elektrische Heizvorrichtung zur Temperierung eines flüssigen Temperiermediums, insbesondere einer Temperierflüssigkeit, die zu gleichen Teilen aus Wasser und Glykol besteht. Die elektrische Heizvorrichtung weist ein versiegeltes Gehäuse 2 mit einem als Kunststoff-Spritzgussteil ausgebildeten wannenförmigen Gehäuseunterteil 4 und einem dieses Gehäuseunterteil 4 dichtend abdeckenden Gehäusedeckel 6 auf. Von einer ersten Stirnseite 8 des Gehäuseunterteils 4 ragen zwei Anschlussstutzen 10 ab, welche einteilig an dem Gehäuseunterteil 4 ausgeformt sind und vorliegend die Rohranschlüsse des Ausführungsbeispiels ausbilden. Der Gehäusedeckel 6 definiert eine Trennwand 12, die oberseitig eine Zirkulationskammer 14 begrenzt, die im Übrigen durch Wandungen des Gehäuseunterteils 4 begrenzt wird, nämlich sich parallel zu den Anschlussstutzen 10 erstreckende Längsseitenwände 16 und sich rechtwinklig hierzu erstreckende Stirnseitenwände 18. Durch eine in Figur 1 erkennbare Abteilwand 20 wird die Zirkulationskammer 14 in zwei Zirkulations-Teilkammern 14a, 14b unterteilt.

Der Gehäusedeckel 6 ist bei dem gezeigten Ausführungsbeispiel nicht nur als Abdeckung für die Zirkulationskammer 14 vorgesehen. Vielmehr bildet der Gehäusedeckel 6 auch Heizrippen 22 mit jeweils U-förmigen Ausnehmungen 24 aus. Die Heizrippen 22 sind einteilig an dem Gehäusedeckel 6 vorgesehen. Der Gehäusedeckel 6 ist als Druckgussteil und aus Aluminium hergestellt. Neben den Heizrippen 22 ragen in Verlängerung der Anschlussstutzen 10 zwei Messfühlerdome 26 in die Zirkulationskammer 14 hinein. Jeder Zirkulations-Teilkammer 14a, 14b ist jeweils ein Messfühlerdom 26a, 26b zugeordnet.

Das Füllvolumen der Zirkulationskammer bei elektrischen Flüssigkeitsheizern der nachstehend beschriebenen Art liegt zwischen 450 ml und 200 ml, bevorzugt zwischen 400 ml und 220 ml und besonders bevorzugt zwischen 300 ml und 230 ml. Dieses Füllvolumen umfasst auch das Füllvolumen des Stutzens. Jeder Stutzen für sich hat ein Füllvolumen von etwa 7 ml. Das gezeigte Ausführungsbeispiel ist üblicherweise in einem Kühlwasserkreislauf in einem Fahrzeug integriert, der ein Volumen von etwa 5 bis 6 Litern hat. In diesen Kühlwasserkreislauf kann zumindest ein Wärmetauscher für die Erwärmung von Luft in der Fahrgastzelle integriert sein. Ergänzend oder alternativ kann auch der Kühlwasserkreislauf Wärmetauscherflächen zu technischen Komponenten eines Elektrofahrzeuges haben, um diese bei kalten Umgebungstemperaturen auf die notwendige Betriebstemperatur zu bringen. Insbesondere dient die elektrische Heizvorrichtung jedenfalls auch der Erwärmung einer Batterie in einem Kraftfahrzeug, welches ausschließlich elektrisch angetrieben werden kann. Der Heizer kann auch so geschaltet sein, dass er sich als Standheizung betreiben lässt, um die Fahrgastzelle vor Inbetriebnahme des Fahrzeugs auf eine für den Benutzer angenehme Temperatur zu erwärmen. Dies erfolgt durch Heizen des flüssigen Fluids, das über einen Wärmetauscher geführt wird, welcher von einem in dem Fahrzeug integrierten Gebläse angestrahlt wird, so dass durch den Wärmetauscher hindurchgeleitete Luft sich an dem Wärmetauscher erwärmt und in die Fahrgastzelle eingeleitet wird. Die Wärmeleistung des elektrischen Zusatzheizers beträgt dabei zwischen 5,0 und 8,0 kW, bevorzugt zwischen 7,0 und 8,0 kW. Diese Heizleistung wird mit einer Ausgestaltung verwirklicht, bei welcher in jeder einzelnen U-förmigen Ausnehmung 24 ein einziges elektrisches Heizelement 28 vorgesehen ist und insgesamt zwischen 9 und 16, bevorzugt zwischen 10 und 14 U-förmige Ausnehmungen in die Zirkulationskammer 14 zwischen 8 und 16, bevorzugt zwischen 10 und 14 Heizrippen 22 hineinragen, die jeweils ein elektrisches Heizelement 28 aufweisen. Die Flächenleistungsdichte liegt zwischen 25 und 27 W/cm².

In jede der U-förmigen Ausnehmungen 24 ist bei dem gezeigten Ausführungsbeispiel ein elektrisches Heizelement 28 eingesetzt. Dieses elektrische Heizelement 28 ist in der EP 1 872 986 A1 bzw. EP 1 921 896 A1 beschriebenen Weise ausgestaltet und in der beispielsweise in EP 2 440 004 A1 bzw. EP 1 931 176 A1 beschriebenen Weise in der U-förmigen Ausnehmung 24 aufgenommen und dort Wärme leitend an die zugeordnete Heizrippe 22 angelegt.

In den Figuren 1 und 2 ist ferner zu erkennen, dass der Gehäusedeckel 6 unter Zwischenlage eines Dichtelementes 32 an dem Gehäuseunterteil 4 anliegt. Das Dichtelement 32 ist in einer an dem Gehäuseunterteil 4 ausgesparten Nut 34 eingebracht und dort gehalten. Das Dichtelement 32 überragt eine stirnseitige Endfläche des Gehäuseunterteils 4, auf welche der Gehäusedeckel 6 aufgesetzt ist.

In der Explosionsdarstellung nach Figur 2 ist oberhalb der als PTC-Heizelemente ausgebildeten elektrischen Heizelemente 28 ein Messleitungsstrang 36 gezeigt, der mit den Signalausgängen von in den Messfühlerdomen 26 eingebrachten Messfühlern 37 elektrisch verbunden ist. Das andere Ende des Messleitungsstranges 36 liegt mit seinen Messleitungsanschlusszungen 38 frei.

Unterhalb davon ist in Figur 2 eine Anschlussleiterplatte 40 dargestellt, die aus einer Kunststoffplatte 42 und einer damit verbundenen gestanzten und elektrische Leiterbahnen ausbildenden Blechplatine 44 gebildet ist. Diese Anschlussleiterplatte 40 ist im Detail in der EP 2 505 931 A1 beschrieben. Der Gehäusedeckel 6 hat einen die Trennwand 12 überragenden umlaufenden Rand 45, der ein Anschlussgehäuse 46 für den elektrischen Anschluss der Kontaktzungen 28.1 der Heizelemente 28 an die Anschlussleiterplatte 40 umgibt. Zwischen dem Rand 45 und einteilig an dem Gehäusedeckel 6 ausgeformten Stegen 49 ist ein halb umlaufender Aufnahmeraum 51 für den Messleitungsstrang 36 vorgesehen.

Zuoberst ist in Figur 2 ein Anschlussgehäusedeckel 48 dargestellt, der aus einer stanzbiegebearbeiteten Blechplatte 50 und einer randseitig daran angespritzten TPE-Dichtung 52 besteht, die in eine an dem Gehäusedeckel 6 ausgesparte Dichtnut 54 eingreift, um das Anschlussgehäuse 46 gegenüber der Umgebung abzudichten. Der Deckel 48 liegt auf den Stegen 49 auf.

Die zuvor beschriebenen Bauteile werden zur Montage der elektrischen Heizvorrichtung in Längsrichtung der U-förmigen Ausnehmungen, d.h. in Z-Richtung ineinander gesetzt, um einerseits die Zirkulationskammer 14 abgedichtet auszubilden und andererseits die PTC-Heizelemente 28 in die U-förmigen Ausnehmungen 24 einzusetzen und über ihre nach oben frei abragenden Kontaktzungen 28.1 elektrisch an die Anschlussleiterplatte 40 anzuschließen. In dieser Fügerichtung werden auch die Thermofühler in die Messfühlerdome 26a, 26b eingesetzt und danach über den Messleitungsstrang 36 elektrisch angeschlossen. Zuletzt wird diese Anordnung durch den Anschlussgehäusedeckel 48 abgedeckt und eingesiegelt, so dass auch die in der Anschlusskammer 30 vorgesehenen elektrischen Leitungsbahnen oberseitig gegenüber der Umgebung abgedichtet sind. Dazu hat die Kunststoffplatte 42 von ihrer Oberseite abragende Abstandshalter 56, die einteilig an der Kunststoffplatte 42 ausgeformt sind und über welche der Anschlussgehäusedeckel 48 sicher von den elektrischen Leiterbahnen der Anschlussleiterplatte 40 beabstandet gehalten ist. Auch wird bei eingepresstem Anschlussgehäusedeckel 48 die auf einen Kunststoffrahmen 58 der PTC-Heizelemente 28 aufgesetzte Anschlussleiterplatte 40 durch die Abstandshalter 56 nieder und in der Einbaulage gehalten.

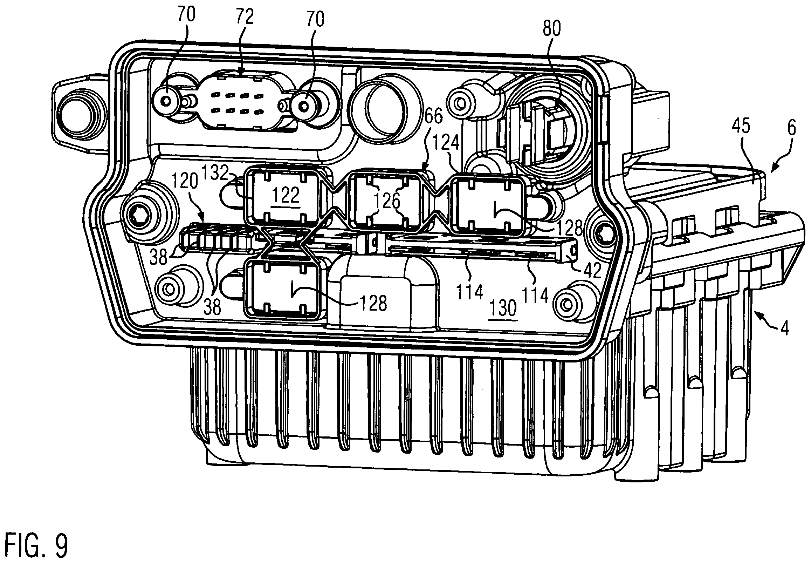

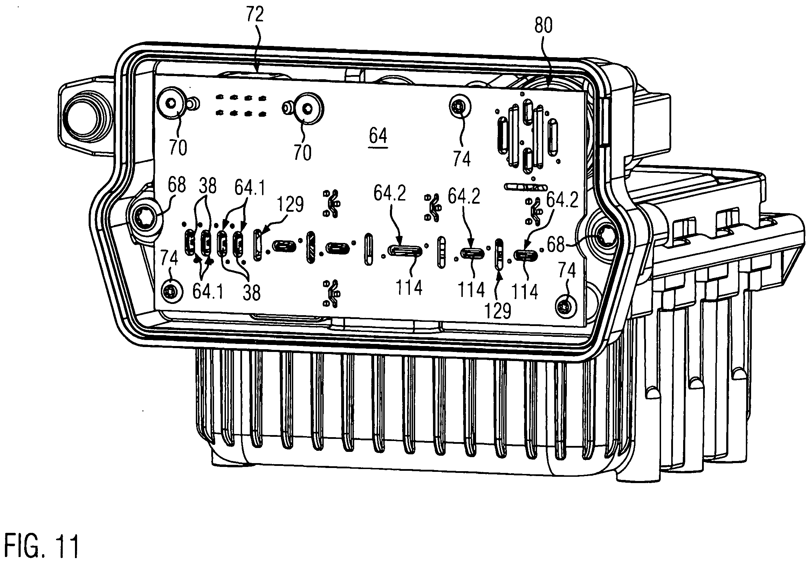

Das in den Figuren 1 und 2 gezeigte Ausführungsbeispiel hat ferner ein metallisches Steuergehäuse 60, in dem eine unter anderem mit Halbleiter-Leistungsschaltern 62 bestückte Steuerleiterplatte 64 angeordnet ist, sowie eine mit Bezugszeichen 66 gekennzeichnete, spritzgegossene Rahmenanordnung 66 aus Kunststoff, auf die nachfolgend noch näher eingegangen werden wird. Befestigungsschrauben 68 dienen der Befestigung des metallischen Steuergehäuses 60 an dem ebenfalls metallischen Gehäusedeckel 6. Steckerbefestigungsschrauben 70 dienen der Befestigung eines Steuersteckers 72 an der Außenseite des Steuergehäuses 60 (vgl. Fig. 9, 11). Mit Bezugszeichen 74 gekennzeichnete Befestigungsstifte dienen der Befestigung der Steuerleiterplatte 64 in dem Steuergehäuse 60 (vgl. Fig. 11).

Mit Bezugszeichen 76 ist ein Masseanschlussstift gekennzeichnet, der das Steuergehäuse 60 in Richtung auf das Gehäuse 2 überragt (vgl. Figur 1). Mit Bezugszeichen 78 ist ein Steuergehäusedeckel gekennzeichnet, der wie der Anschlussgehäusedeckel 48 ausgebildet ist.

Ein mit Bezugszeichen 80 gekennzeichneter Leistungsstecker ist über zwei Sicherungsstifte 82 an der Außenseite des Steuergehäuses 60 befestigt. Schließlich sind zwei längliche Stangen 84 in Figur 2 dargestellt, die als Formschlusselemente einander gegenüberliegende Anlageflächen von Gehäuseunterteil 4 und Gehäusedeckel 6 gegeneinander verriegeln. Gehäuseteil 4 und Gehäusedeckel 6 haben hierzu alternierende einander übergreifende Befestigungsabschnitte 86, 88, auf die nachstehend noch eingegangen werden wird.

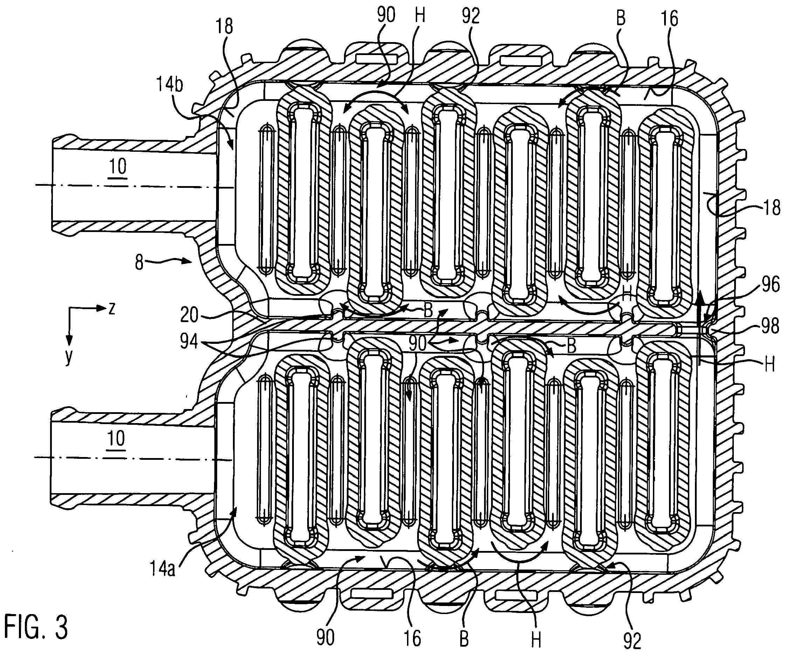

Wie die Schnittansicht in der X-Y-Ebene nach Figur 3 verdeutlicht, sind die einzelnen Heizrippen 22 jeder einzelnen Zirkulations-Teilkammer 14a, 14b in X-Richtung, d.h. Längsrichtung des Gehäuses 2 hintereinander vorgesehen. In jeder der Teilkammern 14a, 14b befindet sich in X-Richtung jeweils eine einzige Heizrippe 22 hinter einer einzigen anderen Heizrippe 22. Die Heizrippen 22 sind allerdings in Y-Richtung alternierend versetzt vorgesehen. Hierdurch ergibt sich ein mit Bezugszeichen 90 gekennzeichneter, mäandrierender Strömungskanal innerhalb der Zirkulations-Teilkammern 14a, 14b, der eine Hauptströmung (Pfeil H) vorgibt. Die einzelnen Heizrippen 22 schließen allerdings mit Ihrer dem Strömungskanal 90 für die Hauptströmung H gegenüberliegenden Seite nicht unmittelbar an die die Zirkulations-Teilkammer 14a, bzw. 14b begrenzende Längsseitenwand 16 bzw. die Abteilwand 20 an. Vielmehr befindet sich dort ein Spalt 92, der eine mit B gekennzeichnete Bypassströmung erlaubt. Wie Figur 3 zu entnehmen ist, hat der Spalt 92 eine Spaltweite entsprechend 5% bis 20%, bevorzugt 7% bis 15 % der lichten Weite zwischen der gegenüberliegenden Stirnseite der entsprechenden Heizrippe 22 und der Längsseitenwand 16 bzw. der Abteilwand 20. Die Spaltweite beträgt vorzugsweise zwischen 3,0 und 0,5 mm, besonders bevorzugt zwischen 2,0 und 0,7 mm. Ganz besonders bevorzugt hat der Spalt eine Weite von zwischen 1,5 und 0,8 mm. Setzt man die jeweilige Spaltweite in Bezug zu der Breite B des Strömungskanals 90, so ergeben sich Verhältnisse von Breite zu Spaltweite von zwischen 4 und 15, bevorzugt zwischen 6 und 10.

Dem Spalt in Strömungsrichtung vorgelagert weist bei dem gezeigten Ausführungsbeispiel jedenfalls die Abteilwand 20 im Strömungskanal 90 Längsrippen 94 auf, durch welche eine Ablösung der Hauptströmung H von der ansonsten eben und gerade verlaufenden Abteilwand 20 abgelöst wird. Wie des Weiteren die Figur 3 erkennen lässt, sind die Heizrippen 22 zu ihrem stirnseitigen Ende hin gegenüber dem mittleren Bereich leicht verdickt. In dem mittleren Bereich bilden die Heizrippen 22 innen ebene Anlageflächen 22.1 für die elektrischen Heizelemente 28 aus.

In Verlängerung der Abteilwand 20 und gegenüberliegend zu den Anschlussstutzen 10 ist ein Strömungsdurchlass 96 vorgesehen, der einen Durchgang der Strömung zwischen den beiden Zirkulations-Teilkammern 14a, 14b erlaubt. Dabei bleibt die Hauptströmung H jedoch in der X-Y-Darstellungsebene gemäß Figur 3. Der Strömungsdurchlass 96 wird wandnah von einer Längsrippe 98 begrenzt, die von der ansonsten ebenen Stirnseitenwand 18 abragt und in Höhenrichtung von einem Boden 100 zu der Trennwand 12 durchlaufend ausgebildet ist.

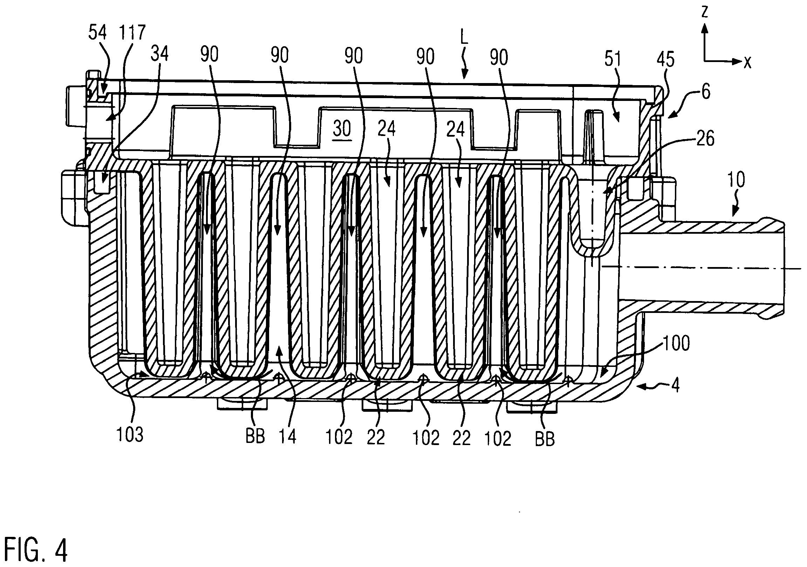

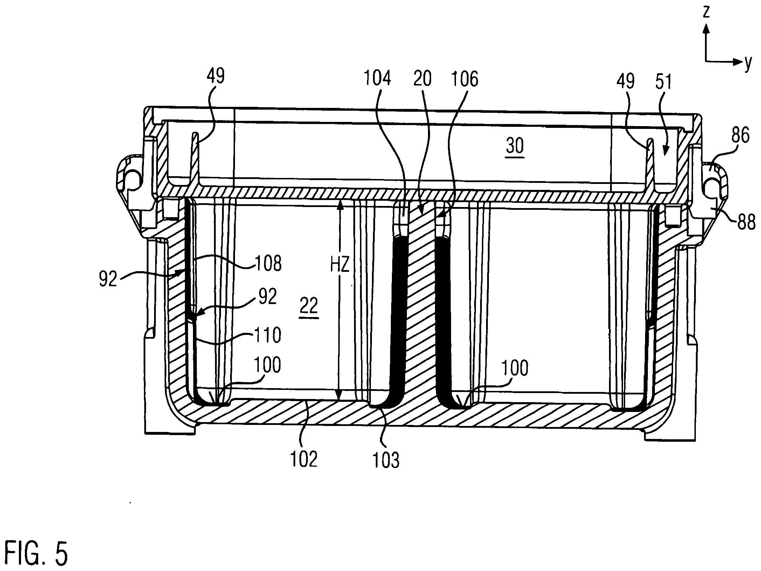

In Figur 3 und insbesondere den Figuren 4 und 5 sind ferner von dem Boden 100 abragende Querrippen 102 zu erkennen, die zwischen benachbarten Heizrippen 22 vorgesehen sind. Die Querrippen 102 überragen das freie untere Ende der Heizrippen 22 (vgl. Figur 4) und sorgen ebenfalls für eine Strömungsablösung von dem Boden 100. Wie ferner aus Figur 4 ersichtlich hat das freie Ende 22.2 der Heizrippe 22 nur einen geringen Abstand von 8 mm bis 10 mm zu dem Boden 100, so dass sich ein Bodenspalt 103 ergibt, der eine Boden-Bypassströmung BB erlaubt.

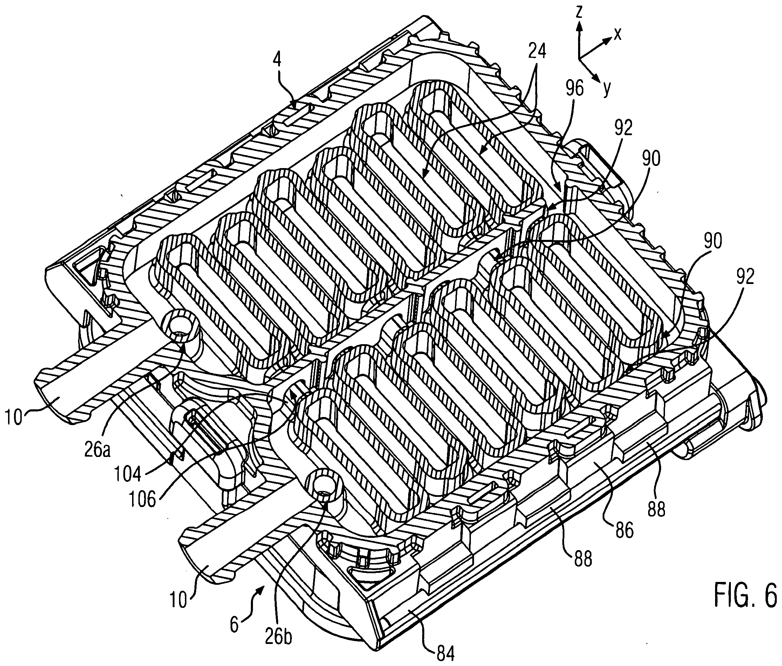

In den zuvor beschriebenen Figuren sowie in Figur 6 sind kartesische Koordinaten X, Y und Z eingetragen. Es ergibt sich aufgrund der vorherigen Beschreibung, dass die Hauptströmung H sich allein in der X-Y-Ebene erstreckt (vgl. Fig. 3). Die Anschlussstutzen 10 liegen auf einer Höhe in Z-Richtung, vgl. Fig. 2. Eine Umlenkung der Hauptströmung H um die jeweiligen Heizrippen 22 erfolgt allein um Umlenkkanten, die sich im Wesentlichen in der Z-Richtung erstrecken, so die Stirnseiten der Heizrippen 22 bzw. die den Strömungsdurchlass 96 begrenzenden Wandungsteile des Gehäuseunterteils 4. Speziell wird die Hauptströmung H nicht zwischen den beiden Zirkulations-Teilkammern 14a, 14b in eine andere, von der vorherigen Strömungsebene in Z-Richtung getrennte Strömungsebene überführt.

Nachstehend werden Details der den Bypassstrom B begrenzenden Wandungen von Gehäuseunterteil 4 und Gehäusedeckel 6 beschrieben, die insbesondere den Figuren 3, 5 und 6 zu entnehmen sind. Dabei ragen die Heizrippen 22 von der im Grunde eben und gerade durchgehend verlaufenden Trennwand 12 ab. In Y-Richtung benachbarte und unterschiedlichen Zirkulations-Teilkammern 14a, 14b zugeordnete Heizrippen 22 sind über einen die Trennwand 12 überragenden Verbindungssteg 104 miteinander verbunden, für welchen die Abteilwand 20 eine korrespondierend hierzu ausgebildete Verbindungsstegaufnahme 106 ausbildet. Eine vollständige Abdichtung zwischen den Zirkulations-Teilkammern 14a, 14b ist nicht notwendig. Gleichwohl ist es gewünscht, durch entsprechende Ausgestaltung der Abteilwand 20 eine Leckageströmung im Wesentlichen zu vermeiden und die Hauptströmung zwischen den Zirkulations-Teilkammern 14a, 14b möglichst vollständig durch den Strömungsdurchlass 96 hindurchzuführen.

Die Heizrippen 22 haben einen den Spalt 92 begrenzenden Heizrippensteg 108, der sich in etwa über 3/5 einer Höhe HZ der Zirkulationskammer erstreckt (vgl. Figur 5). In Fortsetzung dieser Heizrippenstege 108 ist ein von dem Boden 100 abragender und durch das Gehäuseunterteil 4 einteilig ausgeformter Gehäusesteg 110 vorgesehen. Zwischen den jeweiligen Stegen 108, 110 und der gegenüberliegenden Gegenfläche der Heizrippe 22 bzw. des Gehäuseunterteils 6 wird der zuvor erwähnte Spalt 92 gebildet. Die Stege 108, 110 enden in etwa höhengleich, allerdings in Höhenrichtung mit einem geringen Abstand, so dass auch zwischen den Stegen 108, 110 ein die Bypassströmung B ermöglichender Spalt 92 vorgesehen ist.

Nachfolgend werden die besondere Ausgestaltung der Anschlussleiterplatte 40 und das Fügen von Leistungsteil L und Steuerteil S näher erläutert. Der Leistungsteil L besteht dabei aus den Figur 2, links übereinander dargestellten Bauteilen, nämlich dem Gehäuseunterteil 4, dem Dichtelement 32, dem Gehäusedeckel 6, den darin aufgenommenen elektrischen Heizelementen 28, dem Messleitungsstrang 36 und der Anschlussleiterplatte 40 sowie dem diese abdeckenden Anschlussgehäusedeckel 48. Zum Leistungsteil L gehören auch die zum Fügen von Gehäuseunterteil 4 und Gehäusedeckel 6 vorgesehenen Stangen 84. Der Steuerteil S umfasst im Wesentlichen das Steuergehäuse 60, die darin aufgenommene Steuerleiterplatte 64, die zwischen dem Steuergehäuse 60 und der Steuerleiterplatte 64 vorgesehene Rahmenanordnung 66 sowie schließlich den metallischen Steuergehäusedeckel 78. Dabei ist zu vermerken, dass die jeweiligen Deckel 48 und 78 aus gestanztem Blech hergestellt sind und durch Stanzen und Biegen daran einteilig ausgebildete metallische Krallen 112 umfassen, die mit den zugeordneten Wandungen von Gehäusedeckel 6 bzw. Steuergehäuse 60 zusammenwirken, um eine umfängliche Abschirmung zu bilden, die einerseits die Anschlussleiterplatte 40 umschließt und andererseits die Steuerleiterplatte 64.

Beim Herstellen des Leistungsteils L wird der Gehäusedeckel 6 unter Kompression des Dichtelementes 32 auf das Gehäuseunterteil 4 aufgesetzt. Die alternierenden, ineinander greifenden Befestigungsabschnitte 86, 88 gleiten dabei aneinander vorbei. Einander gegenüberliegende Anlageflächen dieser Befestigungsabschnitte 86, 88 werden durch den äußeren Druck so weit voneinander beabstandet, dass die Stangen 84 aus der in Figur 2, rechts gezeigten Lage in X-Richtung zwischen die Anlageflächen der Befestigungsabschnitte 86, 88 gebracht werden können. Danach wird die äußere Kraft entlastet. Das elastisch komprimierte Dichtelement 32 drückt die beiden Teile 4, 6 in Z-Richtung auseinander. Die einander gegenüberliegenden Anlageflächen der Befestigungsabschnitte 86, 88 legen sich schließlich an die Stangen 84 an, welche eine weitere Bewegung der Teile 4, 6 verhindern. Danach sind das Gehäuseunterteil 4 und der Gehäusedeckel 6 formschlüssig miteinander verbunden. Es ergibt sich eine einfache formschlüssige Verbindung der wesentlichen Komponenten des Leistungsteils L.

Dabei stoßen die Stangen 84 in Figur 2, links gegen durch das Gehäuseunterteil 4 ausgebildete Anschlagflächen. So sind die Stangen 84 in ihrer Längsrichtung in X-Richtung einseitig festgelegt. Nach Aufbringen des Steuergehäuses 6, welches in axialer Verlängerung der Stangen 84 Gegenflächen für die Stangen 84 ausbildet, sind auch die Stangen 84 in der anderen Richtung und damit insgesamt in X-Richtung zwischen zwei gegenüberliegenden Anschlägen formschlüssig gesichert, so dass diese am Ort bleiben.

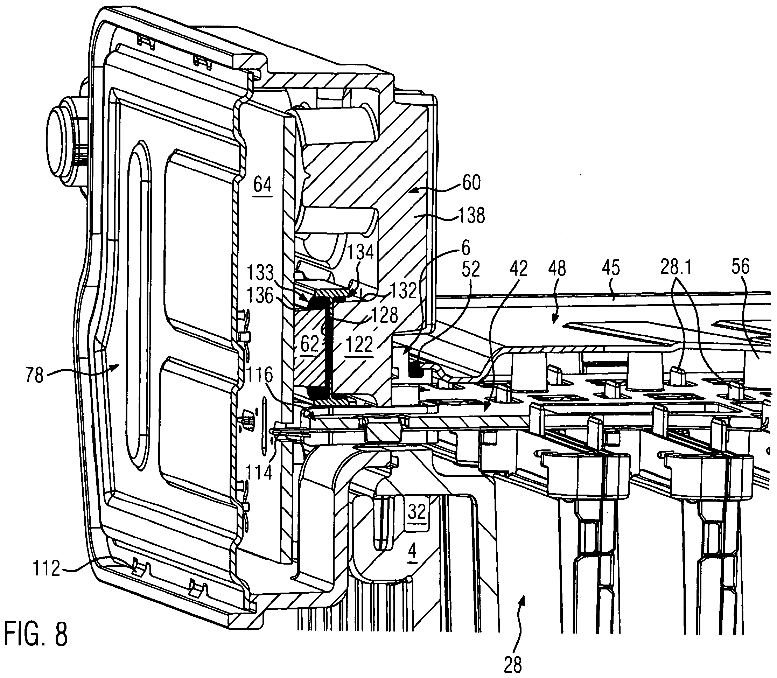

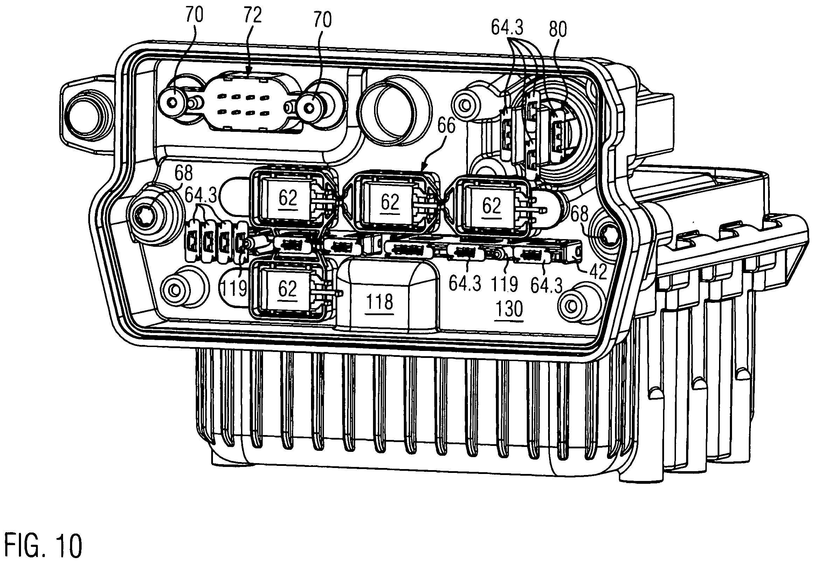

Wie insbesondere der Figur 8 zu entnehmen ist, überragt die Anschlussleiterplatte 40 sowohl mit ihren durch Stanzen der Blechplatine 44 gebildeten Anschlussleiterplatte-Anschlussfahnen 114 wie auch durch einen Endabschnitt 116 der Kunststoffplatte 42 den Leistungsteil L, d.h. das Gehäuse 2. Dazu weist der Gehäusedeckel 6 in dem Rand 45 eine Anschlussleiterplatte-Durchführöffnung 117 auf (vgl. Fig. 4). Auf dieses freiliegende Ende der Anschlussleiterplatte 40 wird das Steuerteil L nach noch nachfolgend zu beschreibender Vormontage der in dem Steuergehäuse 60 aufgenommenen Bauelemente aufgeschoben. Der Figur 10 ist ferner eine Ausgestaltung zu entnehmen, bei welcher der Endabschnitt 116 der Kunststoffplatte 42 zudem noch durch Positionierzapfen 119 überragt ist, welche die Anschlussfahnen 114 überragen.

Wie insbesondere aus Figur 9 ersichtlich, hat das Steuergehäuse 60 eine Anschlussleiterplatten-Anschlussöffnung 118, deren Abmessung exakt auf die Kontur des Endabschnitts 116 der Anschlussleiterplatte 40 angepasst ist, so dass sich eine Schiebeführung ergibt. Dies schließt auch einen leicht verdickten Bereich der Kunststoffplatte 42 ein, welcher - in Figur 9, links dargestellt - Messzungenaufnahmen 120 für die zuvor bereits erwähnten Messleitungsanschlusszungen 38 aufweist. In diesen Messzungenaufnahmen 120 sind die Messleitungsanschlusszungen 38 positioniert gehalten, so dass deren freie Enden wie auch die Anschlussleiterplatten-Anschlussfahnen 114 die Kunststoffplatte 42 überragen.

Figur 9 verdeutlich ferner die zuvor bereits erwähnte Rahmenanordnung 66. Es handelt sich um eine Anordnung von vier Rahmen 124, die als spritzgegossene Einheit aus Silikon hergestellt und mit dem Steuergehäuse über Steckverbinder verbunden ist. Das Steuergehäuse 60 weist Vorsprünge 122 auf, die jeweils von einem einzelnen Rahmen 124 der Rahmenanordnung 66 umgeben sind. Einteilig an der Rahmenanordnung 66 angeformte Haltestege 126 ragen nach innen von den Rahmen 124 ab. Diese Haltestege 126 liegen stirnseitig auf von den jeweiligen Vorsprüngen 122 ausgebildeten ebenen Anlageflächen 128 auf.

Die Rahmen 124 umgeben die Leistungstransistoren 62 in einer nachstehend noch näher zu beschreibenden Weise. Die Steuerleiterplatte 64 wird nach Bestücken mit sämtlichen elektronischen und elektrischen Bauteilen und Steuerelementen zunächst in das Steuergehäuse 60 eingesetzt. Die Steuerleiterplatte 64 wird danach mit den Befestigungsstiften 74 gegenüber dem Steuergehäuse 60 befestigt. Die so vormontierte Einheit aus Steuergehäuse 60, Rahmenanordnung 66 und Steuerleiterplatte 64 wird danach auf das Leistungsteil in einer Richtung aufgeschoben, die quer zur Einbringrichtung der Heizelemente 28 in die U-förmigen Aufnahmen 24 verläuft. Hierbei treffen zunächst die Positionierzapfen 119 auf die Ebene der Steuerleiterplatte 64. Korrespondierend zu den Positionierzapfen 119 sind an vorbestimmten Stellen und in Figur 11 mit Bezugszeichen 129 gekennzeichnete Positionierzapfen-Aufnahmen vorgesehen. In diese Aufnahmen 129 der Steuerleiterplatte 64 greifen die Positionierzapfen 119 mit geringem Spiel in Querrichtung ein. Bei dem gezeigten Ausführungsbeispiel sind diese Positionierzapfen-Aufnahmen 129 als Längsschlitze ausgebildet und geben dementsprechend lediglich eine Positionierung in einer Richtung quer hierzu im Grunde exakt vor. Selbstverständlich können die entsprechenden Öffnungen auch kreisrund und nach einer Art Passung für die Positionierzapfen 119 ausgebildet sein, um die relative Lage zwischen der Anschlussleiterplatte 40 und der Steuerleiterplatte 64 eindeutig vorzugeben. Bei dem gezeigten Ausführungsbeispiel wird die Vorpositionierung indes durch die Passung zwischen den Abmessungen der Kunststoffplatte 42 und der Abmessung der Anschlussöffnung 118 ganz wesentlich mitbestimmt, so dass eine Passung vorliegend zwischen der Positionierzapfen-Aufnahme 129 und dem zugeordneten Positionierzapfen 119 die Position lediglich in Y-Richtung exakt vorgeben muss. Beim weiteren Aufschieben des Steuerteils S auf den Leistungsteil L greifen die freiliegenden Messleitungsanschlusszungen 38 in an der Steuerleiterplatte 64 ausgesparte Bohrungen 64.1 ein, wie dies aus Figur 11 ersichtlich ist. Ferner durchsetzen die Anschlussleiterplatten-Anschlussfahnen 114 Bohrungen 64.2 in der Steuerleiterplatte 64. Dieser Sachverhalt ist ebenfalls in Figur 11 dargestellt. In die entsprechenden Bohrungen 64.1; 64.2 der Steuerleiterplatte 64 sind weibliche Kontaktelemente 64.3 eingebracht, die mit der Steuerleiterplatte 64 mechanisch und dadurch mit Leiterbahnen der Steuerleiterplatte 64 elektrisch verbunden sind, wie sie in der EP 2 236 330 A1 der vorliegenden Anmelderin beschrieben sind. (Die weiblichen Kontaktelemente 64.3 sind in Figur 10 ohne die zugehörige Steuerleiterplatte 64 aus Darstellungsgründen isoliert dargestellt.) So ist die Steuerleiterplatte 64 nach dem Aufschieben des vormontierten Steuergehäuses 60 in X-Richtung gegen das Leistungsteil L elektrisch mit der Anschlussleiterplatte 40 verbunden. Üblicherweise wird vor dem Aufschieben des Steuergehäuses 60 das Steuerteil S vollständig vormontiert, d.h. das Steuergehäuse 60 mit dem Steuergehäusedeckel 78 verschlossen.

Nachstehend wird die besondere Ausgestaltung des Steuergehäuses 60 und die darin verwirklichte Montage der Halbleiter-Leistungsschalter 62 beschrieben.

Das aus Metall gebildete Steuergehäuse 60 hat vorliegend vier rechteckige Anlageflächen 128, die jeweils durch die Gehäusevorsprünge 122 ausgebildet sind, die von einem im Grunde ebenen Steuergehäuseboden 130 in Richtung auf die Steuerleiterplatte 64 vorspringen. Seitlich neben den oberen drei Gehäusevorsprüngen 122 sind jeweils den Steuergehäuseboden 130 überragende Montagezapfen durch das das Steuergehäuse 60 bildende Material einteilig ausgeformt, welche mit einer Bohrung versehen sind, in welche Befestigungszapfen der Rahmenanordnung 66 eingreifen und dort befestigt sind. Eine entsprechende Ausgestaltung ergibt sich links von dem unteren Gehäusevorsprung 122 gemäß der Darstellung von Figur 9. Wie sich weiter aus dieser Figur ergibt, weist jeder Rahmen 124 der Rahmenanordnung 66 vier Haltestege 126 auf, die oben auf der Anlagefläche 128 aufliegen und von einem umfänglich die Anlagefläche 128 umgebenden Rand nach innen vorspringen. Die Rahmen 124 umschließen den Gehäusevorsprung 128 mit einem gewissen Abstand. Die Rahmen 124 haben ferner - wie insbesondere aus Figur 8 ersichtlich - eine in Richtung auf den Steuergehäuseboden 130 vorspringenden unteren Rand 124.1, der den Haltesteg 126 nach unten überragt und jedenfalls teilweise eine Umfangsfläche 132 des Gehäusevorsprungs 122 umgibt, sowie einen in die entgegen gesetzte Richtung abragenden oberen Rand 124.2, der zwischen dem Leistungsschalter 62 und dem Rahmen 124 einen Zwischenraum 133 vorgibt. Durch die Anordnung des unteren Randes 124.1 mit Abstand zu dem Gehäusevorsprung 122 ergibt sich zwischen dem Rahmen 124 und diesem Gehäusevorsprung 122 ein umlaufender, d.h. ringförmiger Klebespalt 134.

Die Figur 8 zeigt die Situation nach dem Einbau der zunächst vormontierten und als bauliche Einheit in das Steuergehäuse 60 eingebrachten Steuerleiterplatte 64. Dabei liegen die Halbleiter-Leistungstransistoren 62 stirnseitig gegen die Haltestege 126 an, welche dementsprechend einen definierten Abstand zwischen den Halbleiter-Leistungstransistoren 62 und der Anlagefläche 128 vorgeben. Jeglicher Zwischenraum zwischen der Anlagefläche 128 und dem Halbleiter-Leistungstransistor 62 ist durch einen Silikonkleber 136 ausgefüllt, der vorliegend ein Ausführungsbeispiel für die adhäsive Masse darstellt. Der Silikonkleber 136 hat eine gute Wärmeleitfähigkeit, ist indes elektrisch isolierend. Der obere Rand 124.2 umschließt einen Montageraum 137 für den Halbleiter-Leistungsschalter 62, der nach dem Einbringen desselben in den Rahmen 124 vollständig von dem Silikonkleber 136 ausgefüllt ist. Wie insbesondere aus Figur 8 ersichtlich ist, überragt der Silikonkleber 136 gar das zu der Steuerleiterplatte 64 vorspringende Ende des oberen Randes 124.2

Zur Montage wird der Silikonkleber 136 zunächst auf die Anlagefläche 128 aufgebracht. Danach wird die vormontierte Steuerleiterplatte 64 in das Steuergehäuse 60 eingebracht. Zum Ende dieser Einbringbewegung trifft die stirnseitige Vorderfläche der jeweiligen Halbleiter-Leistungstransistoren 62 auf den Silikonkleber 136. Dieser wird bei fortschreitender Einbringbewegung der Steuerleiterplatte 64 zunächst in der Ebene verdrängt und verteilt sich gleichmäßig auf der Anlagefläche 128. Es ist aber so viel Silikonkleber 136 auf jede der Anlageflächen 126 aufgebracht, dass die von dem Rahmen 124 jeweils umgebene Anlagefläche 128 nicht nur vollständig in Umfangsrichtung mit dem Silikonkleber 136 benetzt wird. Vielmehr steigt der Silikonkleber 136 durch das Verdrängen des Volumens zwischen der Anlagefläche 128 und dem Halbleiter-Leistungstransistor 62 sowohl in Richtung auf die Steuerleiterplatte 64 als auch in den Klebespalt 134. So ergibt sich eine gute Einsiegelung des Halbleiter-Leistungstransistors 62. Auch ist der Rahmen 124 relativ großflächig mit dem Silikonkleber 136 und damit haftvermittelnd und fest mit dem Steuergehäuse 60 verbunden. Des Weiteren sorgt der Silikonkleber 136 aufgrund seiner guten Wärmeleitfähigkeit zu einer guten Ableitung der von dem Halbleiter-Leistungstransistor 62 erzeugten Verlustleistung. Auf der dem Halbleiter-Leistungstransistor 62 gegenüberliegenden Seite bildet das Steuergehäuse 60 einteilig daran angeformte Kühlrippen 138 aus. Diese sind zumindest auch genau gegenüberliegend zu den jeweiligen Halbleiter-Leistungstransistoren 62 vorgesehen.

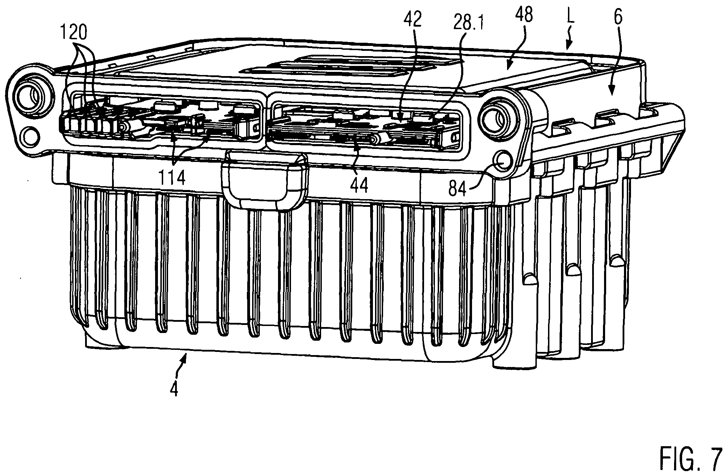

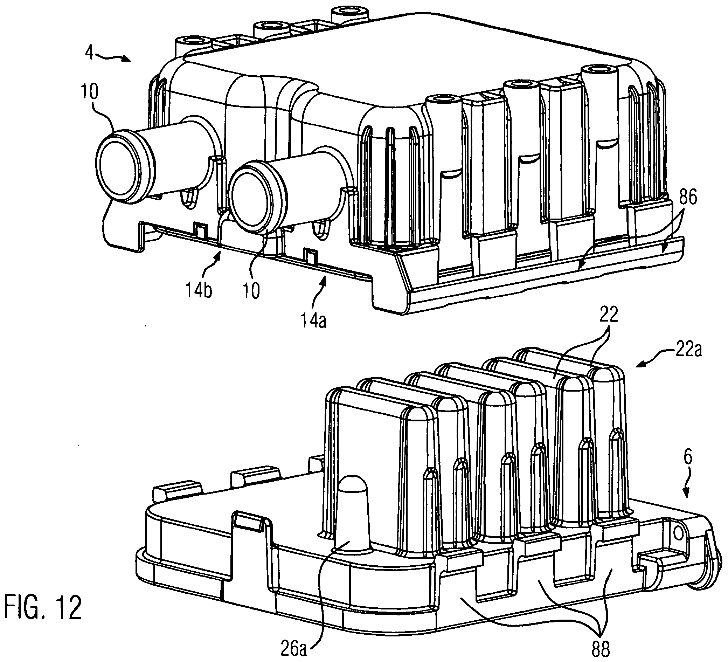

Die Figur 12 zeigt eine Abwandlung zu dem zuvor diskutierten Ausführungsbeispiel. Dieses kann mit denselben Komponenten wie zuvor beschrieben bestückt sein, um den Leistungsteil L auszubilden. Auch kann der Steuerteil S in identischer Weise ausgebildet und seitlich an den Leitungsteil L angeflanscht sein. Das in Figur 12 gezeigte Ausführungsbeispiel des Gehäuses 2 unterscheidet sich lediglich dadurch von dem Leistungsteil L nach den vorherigen Figuren, dass der Gehäusedeckel 4 lediglich eine Reihe von in Richtung hintereinander vorgesehenen Heizrippen 22a aufweist. Diese sind in Verlängerung des Einlassstutzens 10 vorgesehen. In der anderen Zirkulations-Teilkammer 14b befinden sich keine Heizrippen 22. Diese Zirkulations-Teilkammer 14b dient lediglich der Rückführung des zu erwärmenden Fluids. Die Zirkulations-Teilkammer 14a ist dementsprechend wie bei dem zuvor diskutierten Ausführungsbeispiel aufgebaut; die Zirkulations-Teilkammer 14b dient aber lediglich der Strömungsrückführung zu dem Auslassstutzen 10, links in Fig. 12. So hat das Ausführungsbeispiel nach Figur 12 auch lediglich in etwa die Hälfte der Wärmeleistung im Vergleich zu dem unter Bezugnahme auf die Figuren 1 bis 11 diskutierten ersten Ausführungsbeispiel.

### Bezugszeichenliste

- 2: Gehäuse
- 4: Gehäuseunterteil
- 6: Gehäusedeckel
- 8: erste Stirnseite
- 10: Anschlussstutzen
- 12: Trennwand
- 14: Zirkulationskammer
- 14a, 14b: Zirkulations-Teilkammer
- 16: Längsseitenwand
- 18: Stirnseitenwand
- 20: Abteilwand
- 22: Heizrippe
- 22.1: ebene Anlagefläche der Heizrippe
- 22.2: freies Ende der Heizrippe
- 24: U-förmige Ausnehmungen
- 26a, 26b: Messfühlerdom
- 28: elektrisches Heizelement
- 28.1: Kontaktzunge
- 30: Anschlusskammer
- 32: Dichtelement
- 34: Nut
- 36: Messleitungsstrang
- 37: Messfühler
- 38: Messleitungsanschlusszunge
- 40: Anschlussleiterplatte
- 42: Kunststoffplatte
- 44: Blechplatine
- 45: Rand
- 46: Anschlussgehäuse
- 48: Anschlussgehäusedeckel
- 49: Steg
- 50: Blechplatte
- 51: Aufnahmeraum
- 52: TPE-Dichtung
- 54: Dichtnut
- 56: Abstandshalter
- 58: Kunststoffrahmen
- 60: Steuergehäuse
- 62: Halbleiter-Leistungsschalter /-Leistungstransistor
- 64: Steuerleiterplatte
- 64.1: Bohrung für Messleitungsanschlusszunge 38
- 64.2: Bohrung für Anschlussleiterplatten-Anschlussfahne 114
- 64.3: weibliche Kontaktelemente
- 66: Rahmenanordnung
- 68: Befestigungsschraube
- 70: Steckerbefestigungsschraube
- 72: Steuerstecker
- 74: Befestigungsstift
- 76: Masseanschlussstift
- 78: Steuergehäusedeckel
- 80: Leistungsstecker
- 82: Sicherungsstift
- 84: Stange
- 86: Befestigungsabschnitt des Gehäuseunterteils
- 88: Befestigungsabschnitt des Gehäusedeckels
- 90: Strömungskanal
- 92: Spalt
- 94: Längsrippe (Abteilwand 20)
- 96: Steuerungsdurchlass
- 98: Längsrippe (Strömungsdurchlass 96)
- 100: Boden
- 102: Querrippe
- 103: Bodenspalt
- 104: Verbindungssteg
- 106: Verbindungsstegaufnahme
- 108: Heizrippensteg
- 110: Gehäusesteg
- 112: Kralle
- 114: Anschlussleiterplatten-Anschlussfahne
- 116: Endabschnitt
- 117: Anschlussleiterplatten-Durchführöffnung
- 118: Anschlussleiterplatten-Anschlussöffnung
- 119: Positionierzapfen
- 120: Messzungenaufnahme
- 122: Gehäusevorsprung
- 124: Rahmen
- 124.1: unterer Rand
- 124.2: oberer Rand
- 126: Haltesteg
- 128: Anlagefläche
- 129: Positionierzapfen-Aufnahme
- 130: Steuergehäuseboden
- 132: Umfangsfläche
- 133: Zwischenraum
- 134: Klebespalt
- 136: Silikonkleber
- 137: Montageraum
- 138: Kühlrippe

- B: Bypassströmung
- BB: Boden-Bypassströmung
- H: Hauptströmung
- HZ: Höhe der Zirkulationskammer 14
- L: Leistungsteil
- S: Steuerteil

## Patentansprüche

1. Elektrische Heizvorrichtung, insbesondere für ein Kraftfahrzeug, mit einem Gehäuse (2), welches eine von einem Medium durchströmbare Zirkulationskammer (14) umschließt, in welche wenigstens eine Heizrippe (22) hineinragt, die sich zu einer Anschlusskammer (30) öffnet, in der elektrische Anschlusselemente (28.1) von wenigstens einem elektrischen Heizelement (28) der Heizrippe (22) hineinragen, wobei die Anschlusselemente (28.1) über eine Anschlussleiterplatte (40) elektrisch angeschlossen sind,
**dadurch gekennzeichnet,**
**dass** die Anschlussleiterplatte (40) seitlich über das Gehäuse (2) hinaus verlängert ausgebildet und durch eine Anschlussleiterplatten-Anschlussöffnung (118) eines Steuergehäuses (60) hindurchgeführt ist und dass an der Anschlussleiterplatte (40) ausgebildete Leiterbahnen unmittelbar mit Leiterbahnen einer Steuerleiterplatte (64) kontaktiert sind, die in dem Steuergehäuse aufgenommen ist.

2. Elektrische Heizvorrichtung nach Anspruch 1, **dadurch gekennzeichnet, dass** die Anschlussleiterplatten-Anschlussöffnung (118) als Schiebeführung für die Anschlussleiterplatte (40) ausgebildet ist.

3. Elektrische Heizvorrichtung nach Anspruch 1 oder 2, **dadurch gekennzeichnet, dass** die Anschlussleiterplatte (40) die männlichen Steckelemente (38, 114) und die Steuerleiterplatte (64) die weiblichen Steckelemente (64.3) einer elektrischen Steckverbindung zwischen der Anschlussleiterplatte (40) und der Steuerleiterplatte (64) ausbilden.

4. Elektrische Heizvorrichtung nach einem der vorherigen Ansprüche, **dadurch gekennzeichnet, dass** die Anschlussleiterplatte (40) aus einer Kunststoffplatte (42) und einer damit verbundenen gestanzten und elektrische Leiterbahnen ausbildenden Blechplatine (44) gebildet ist und dass die Kunststoffplatte (42) zumindest eine Messzungenaufnahme (120) für wenigstens eine Messleitungsanschlusszunge (38) eines zu in dem Gehäuse (2) aufgenommenen Messfühlers führenden Messleitungsstrangs (36) ausbildet, wobei die Messleitungsanschlusszungen (38) elektrisch an Leiterbahnen der Steuerleiterplatte (64) angeschlossen sind.

5. Elektrische Heizvorrichtung nach einem der vorherigen Ansprüche, **dadurch gekennzeichnet, dass** die Steuerleiterplatte (64) mit dem Steuergehäuse (60) verschraubt ist.

6. Elektrische Heizvorrichtung nach einem der vorherigen Ansprüche, **dadurch gekennzeichnet, dass** die Steuerleiterplatte (64) sich im Wesentlichen rechtwinklig zu der Anschlussleiterplatte (40) erstreckt.

7. Verfahren zur Herstellung einer elektrischen Heizvorrichtung gemäß Anspruch 1, insbesondere für ein Kraftfahrzeug, mit einem Gehäuse (2), welches eine von einem Medium durchströmbare Zirkulationskammer (14) umschließt, in welche wenigstens eine Heizrippe (22) hineinragt, die sich zu einer Anschlusskammer (30) öffnet, in der elektrische Anschlusselemente (28.1) wenigstens eines elektrischen Heizelementes (28) der Heizrippe (22) hineinragen, wobei die Anschlusselemente (28.1) über eine Anschlussleiterplatte (40) elektrisch angeschlossen sind, wobei zunächst das elektrische Heizelement in der Heizrippe (22) angeordnet und danach die Anschlussleiterplatte (40), welche im montierten Zustand seitlich über das Gehäuse (2) hinaus verlängert ausgebildet ist, auf die Anschlusselemente (28.1) aufgeschoben wird, um Leiterbahnen der Anschlussleiterplatte (40) mit den Anschlusselementen (28.1) zu kontaktieren, ein Steuergehäuse (60) in einer im Wesentlichen in der Ebene der Anschlussleiterplatte (40) liegenden Richtung auf die Anschlussleiterplatte (40) aufgeschoben und die Auschlussleiterplatte (40) dabei durch eine Auschlussleiterplatten-Auschlussöffnung (118) des Steuergehäuses (60) hindurchgeführt wird und elektrische Anschlusselemente (38; 114) der Anschlussleiterplatte (40) mit Leiterbahnen einer in dem Steuergehäuse (60) vorgesehenen Steuerleiterplatte (64) durch Aufstecken der Anschlussleiterplatte (40) auf die Steuerleiterplatte (64) verbunden werden.

## Claims

1. Electric heating device, particularly for an automotive vehicle, comprising a housing (2) which encloses a circulation chamber (14) through which a medium can flow and into which at least one heating rib (22) projects that opens towards a connection chamber (30) into which electric connection elements (28.1) of at least one electric heating element (28) of the heating rib (22) project, the connection elements (28.1) being electrically connected via a connection circuit board (40),
**characterized in**
**that** the connection circuit board (40) is configured to extend laterally beyond the housing (2) and is passed through a connection-circuit-board connection opening (118) of a control housing (60), and that conductor paths formed on the connection circuit board (40) are directly contacted with conductor paths of a control circuit board (64) which is received in the control housing.

2. Electric heating device according to claim 1, **characterized in that** the connection-circuit-board connection opening (118) is configured as a slide guide for the connection circuit board (40).

3. Electric heating device according to claim 1 or 2, **characterized in that** the connection circuit board (40) forms the male plug elements (38, 114) and the control circuit board (64) forms the female plug elements (64.3) of an electric plug connection between the connection circuit board (40) and the control circuit board (64).

4. Electric heating device according to any one of the preceding claims, **characterized in that** the connection circuit board (40) is made from a plastic plate (42) and a punched sheet-metal board (44) which is connected thereto and forms electric conductor paths, and that the plastic plate (42) forms at least one measuring tongue receptacle (120) for at least one measuring-line connection tongue (38) of a measuring line section (36) leading to sensors received in the housing (2), wherein the measuring-line connection tongues (38) are electrically connected to conductor paths of the control circuit board (64).

5. Electric heating device according to any one of the preceding claims, **characterized in that** the control circuit board (64) is screwed to the control housing (60).

6. Electric heating device according to any one of the preceding claims, **characterized in that** the control circuit board (64) extends substantially at a right angle relative to the connection circuit board (40).

7. Method for producing an electric heating device according to claim 1, particularly for an automotive vehicle, comprising a housing (2) which encloses a circulation chamber (14) through which a medium can flow and into which at least one heating rib (22) projects that opens towards a connection chamber (30) into which electric connection elements (28.1) of at least one electric heating element (28) of the heating rib (22) project, wherein the connection elements (28.1) are electrically connected via a connection circuit board (40), wherein the electric heating element is first arranged in the heating rib (22) and the connection circuit board (40) which in the mounted state is configured to extend laterally beyond the housing (2) is then slid onto the connection elements (28.1) to contact conductor paths of the connection circuit board (40) with the connection elements (28.1), a control housing (60) is slid, in a direction substantially located in the plane of the connection circuit board (40), onto the connection circuit board (40), and the connection circuit board (40) is thereby passed through a connection-circuit-board connection opening (118) of the control housing (60), and electric connection elements (38, 114) of the connection circuit board (40) are connected to conductor paths of a control circuit board (64), which is provided in the control housing (60), by plugging the connection circuit board (40) onto the control circuit board (64).

## Revendications

1. Dispositif de chauffage électrique, notamment pour un véhicule automobile, comprenant un boitier (2), qui enferme une chambre de circulation (14) à travers laquelle s'écoule un fluide et dans laquelle s'engage au moins une nervure de chauffage (22), qui s'ouvre en direction d'un compartiment de raccordement (30) dans lequel s'engagent des éléments de raccordement électriques (28.1) d'au moins un élément chauffant électrique (28) de la nervure de chauffage (22), les éléments de raccordement (28.1) étant raccordés électriquement par l'intermédiaire d'une plaque de circuit imprimé de raccordement (40),
**caractérisé**
**en ce que** la plaque de circuit imprimé de raccordement (40) est réalisée de manière prolongée latéralement au-delà du boitier (2) et traverse une ouverture de raccordement de plaque de circuit imprimé de raccordement (118) d'un boitier de commande (60), et en ce que des pites conductrices formées sur la plaque de circuit imprimé de raccordement (40) sont mises en contact direct avec des pistes conductrices d'une plaque de circuit imprimé de commande (64), qui est logée dans le boitier de commande.

2. Dispositif de chauffage électrique selon la revendication 1, **caractérisé en ce que** l'ouverture de raccordement de plaque de circuit imprimé de raccordement (118) est réalisée en tant qui guidage coulissant pour la plaque de circuit imprimé de raccordement (40).

3. Dispositif de chauffage électrique selon la revendication 1 ou la revendication 2, **caractérisé en ce que** la plaque de circuit imprimé de raccordement (40) réalise les éléments enfichables mâles (38, 114) et la plaque de circuit imprimé de commande (64) les éléments enfichables femelles (64.3) d'une liaison de connexion électrique par enfichage entre la plaque de circuit imprimé de raccordement (40) et la plaque de circuit imprimé de commande (64).

4. Dispositif de chauffage électrique selon l'une des revendications précédentes, **caractérisé en ce que** la plaque de circuit imprimé de raccordement (40) est formée par une plaque de matière plastique (42) et, reliée à celle-ci, une platine de tôle (44) découpée et formant des pistes conductrices électriques, et **en ce que** la plaque de matière plastique (42) forme au moins un logement d'accueil de languette de mesure (120) pour au moins une languette de raccordement de conducteur de mesure (38) d'une branche de conducteur de mesure (36) menant à une sonde de température logée dans le boitier (2), les languettes de raccordement de conducteur de mesure (38) étant raccordées électriquement à des pistes conductrices de la plaque de circuit imprimé de commande (64).

5. Dispositif de chauffage électrique selon l'une des revendications précédentes, **caractérisé en ce que** la plaque de circuit imprimé de commande (64) est vissée au boitier de commande (60).

6. Dispositif de chauffage électrique selon l'une des revendications précédentes, **caractérisé en ce que** la plaque de circuit imprimé de commande (64) s'étend sensiblement de manière perpendiculaire à la plaque de circuit imprimé de raccordement (40).

7. Procédé de fabrication d'un dispositif de chauffage électrique selon la revendication 1, notamment pour un véhicule automobile, comprenant un boitier (2), qui enferme une chambre de circulation (14) à travers laquelle s'écoule un fluide et dans laquelle s'engage au moins une nervure de chauffage (22), qui s'ouvre en direction d'un compartiment de raccordement (30) dans lequel s'engagent des éléments de raccordement électriques (28.1) d'au moins un élément chauffant électrique (28) de la nervure de chauffage (22), les éléments de raccordement (28.1) étant raccordés électriquement par l'intermédiaire d'une plaque de circuit imprimé de raccordement (40), procédé d'après lequel on dispose tout d'abord l'élément chauffant électrique dans la nervure de chauffage (22) et on engage ensuite la plaque de circuit imprimé de raccordement (40), qui dans l'état monté est réalisée de manière prolongée latéralement au-delà du boitier (2), sur les éléments de raccordement (28.1), en vue de mettre en contact des pistes conductrices de la plaque de circuit imprimé de raccordement (40) avec les éléments de raccordement (28.1),
d'après lequel on engage un boitier de commande (60) sur la plaque de circuit imprimé de raccordement (40), dans une direction située sensiblement dans le plan de la plaque de circuit imprimé de raccordement (40), en faisant à cette occasion traverser à la plaque de circuit imprimé de raccordement (40), une ouverture de raccordement de plaque de circuit imprimé de raccordement (118) du boitier de commande (60), et d'après lequel des éléments de raccordement électriques (38; 114) de la plaque de circuit imprimé de raccordement (40) sont reliés à des pistes conductrices d'une plaque de circuit imprimé de commande (64) prévue dans le boitier de commande (60), en enfichant la plaque de circuit imprimé de raccordement (40) sur la plaque de circuit imprimé de commande (64).
